# EUROPÄISCHE PATENTANMELDUNG

(11) **EP 2 237 654 A2**
(43) Veröffentlichungstag der Anmeldung: **06.10.2010**
(21) Anmeldenummer: 10152592.1
(22) Anmeldetag: 04.02.2010
(51) Int. Cl.: H05K 13/08

(54) **Verfahren zum Erfassen und Verfolgen von zu bestückenden Elementen**

(30) Priorität: 30.03.2009 DE 102009015496
(71) Anmelder: Siemens Electronics Assembly Systems GmbH & Co. KG, 81379 München (DE)
(72) Erfinder: Struck, Günter, 45136 Essen (DE)
(74) Vertreter: Maier, Daniel Oliver

(57) **Zusammenfassung**

Die Erfindung betrifft ein Verfahren zum Erfassen und Verfolgen von zu bestückenden Elementen (B1, B2, ..., Bx), welche durch einen Bestückvorgang in einer Bestückeinrichtung (BE), insbesondere in SMD-Bestückautomaten und/oder Bestücklinien, auf ein Substrat (LP) aufgebracht werden. Das Substrat (LP) wie z.B. eine Leiterplatte oder ein Werkstoffträger weist dabei üblicherweise eine eindeutige Substrat-Identifikation (BC) auf. Die zu bestückenden Elemente (B1, B2, ..., Bx) wie beispielsweise elektronische Bauelemente und/oder Submodule werden ebenfalls mit einer eindeutigen Kennung versehen. Vor einem Bestückvorgang wird die Substrat-Identifikation (BC) des jeweils zu bestückenden Substrats (LP) erfasst (1, 2). Dann wird während des jeweiligen Bestückvorgangs die eindeutige Kennung des jeweils zu bestückenden Elements (B1, B2, ..., Bx) erfasst (3, 4) - z.B. optisch mittels eines Scanners (SC) oder einer Kamera (BK). Dann werden die eindeutige Kennung des jeweils zu bestückenden Elements (B1, B2, ..., Bx) und die erfasste, eindeutige Substrat-Identifikation (BC) miteinander verknüpft (6). So erhaltene Daten (VP) können dann elektronisch gespeichert, versendet und von Datenverarbeitungseinrichtungen (DV) entsprechend verarbeitet werden (7). Das erfindungsgemäße Verfahren weist den Vorteil auf, dass auf einfache Weise eine eindeutige Verknüpfung zwischen bestücktem Element(B1, B2, ..., Bx), Substrat (LP) und gegebenenfalls einem Endprodukt hergestellt wird, wodurch eine genaue Verfolgung und Identifikation von einzelnen Elementen (B1, B2, ..., Bx) ohne großen Aufwand ermöglicht ist.

## Beschreibung

### Technisches Gebiet

Die vorliegende Erfindung betrifft ein Verfahren zum Erfassen und Verfolgen von zu bestückenden Elementen, welche durch einen Bestückvorgang in einer Bestückeinrichtung, insbesondere in so genannten SMD-Bestückautomaten und/oder Bestücklinien, auf ein Substrat aufgebracht werden. Das Substrat wie z.B. eine Leiterplatte oder ein Werkstoffträger weist dabei üblicherweise eine eindeutige Substrat-Identifikation auf.

### Stand der Technik

In der Bestücktechnik, insbesondere bei der so genannten Surface-mounted Technology (SMT), werden zu bestückende Elemente wie z.B. elektronische Bauelemente, Bauelementgruppen, etc. von Bestückeinrichtungen (z.B. Bestückautomaten, Bestücklinien) insbesondere so genannten SMD-(Surface-mounted Device)-Bestückautomaten auf einer Oberfläche eines Substrats (z.B. Leiterplatte) angebracht.

Bei einem Bestückvorgang wird ein zu bestückendes Element mit Hilfe einer Bauelementehalteeinrichtung (z.B. Bestückkopf) auf dem Substrat aufgebracht. Dabei wird zuerst das zu bestückende Element mit der Bauelementehalteeinrichtung aus einer so genannten Zuführeinrichtung entnommen, von welcher die zu bestückenden Elemente für den jeweiligen Bestückvorgang an einer Abholposition bereitgestellt werden. Von der durch ein Positioniersystem verfahrbare Bauelementehalteeinrichtung wird das jeweils zu bestückende Element an der Abholposition abgeholt und zu einem Bestückbereich der Bestückeinrichtung bzw. des SMD-Bestückautomaten verfahren. Dort wird dann das jeweils zu bestückende Element von der Bauelementehalteeinrichtung bzw. dem Bestückkopf auf dem Substrat bzw. auf der Leiterplatte an einer für dieses Element vorgesehenen Stelle abgesetzt.

Für den nächsten Bestückvorgang wird dann von der Bauelementehalteeinrichtung das nächste zu bestückende Element von der Abholposition geholt und auf dem Substrat angebracht. Die Bestückvorgänge werden dabei so lange wiederholt, bis alle von der Bestückeinrichtung zu bestückenden Positionen des Substrats bzw. der Leiterplatte mit Elementen besetzt worden sind. Dann wird beispielsweise das bestückte Substrat mittels einer Transporteinrichtung (z.B. Fließband) zu einer nächsten Station (z.B. weiterer Bestückautomat für weitere Bestückvorgänge, Reflow-Ofen zum Löten, etc.) abtransportiert. Das nächste Substrat bzw. die nächste Leiterplatte wird dann von der Transporteinrichtung in den Bestückbereich der Bestückeinrichtung bewegt und mit Elementen bestückt.

Die Elemente für die Bestückvorgänge werden üblicherweise in Behältern geliefert und gelagert. So werden beispielsweise zu bestückende Elemente für SMD-Bestückautomaten in so genannten Bauelementgurten gelagert, welche Vertiefungen - so genannte Taschen - aufweisen, in denen die zu bestückenden Elemente untergebracht sind. Um ein Herausfallen der zu bestückenden Elemente zu verhindern z.B. während Lagerung oder Transport zu verhindern, ist der Bauelementegurt mittels einer Abdeckfolie verschlossen, welche abgezogen wird, um ein Element für eine Bestückvorgang zu entnehmen. Für die Lagerung und eine Zufuhr zum Bestückprozess in z.B. einem SMD-Bestückautomaten sind die Bauelementgurte auf Gurtrollen aufgerollt. Für die Bestückvorgänge wird die Gurtrolle in die Zuführeinrichtung eingelegt und ein Stück des Gurts, von welchem die Abdeckfolie abgelöst worden ist, in die Zuführeinrichtung eingefädelt.

Andere zu bestückende Elemente wie z.B. größere Bauelemente (z.B. Kondensatoren, etc.) oder Integrierte Schaltungen (ICs) werden beispielsweise in Kunststoffstangen oder auf kleinen Paletten, so genannten Trays, verpackt und gelagert. Die Kunststoffstangen werden dann für die Bestückvorgänge ebenfalls in spezielle Zuführeinrichtungen eingelegt. Die Paletten, auf welchen zu bestückenden Elemente (z.B. Integrierte Schaltungen, etc.) gelagert sind, können beispielsweise direkt in eine Bestückeinrichtung eingebracht werden.

Mit Elementen wie z.B. elektronischen Bauelementen und Submodulen bestückte Substrate bzw. Leiterplatten werden in vielen verschiedenen Bereichen wie beispielsweise elektronischen Geräten, Anlagen, Automotive-Industrie, Flugzeugbau, etc. eingesetzt, von welchen bestimmte Qualitätskriterien gefordert sind. Daher werden von Herstellern bestückter Substrate bzw. von Produkten mit bestückten Substraten üblicherweise Qualitätsprüfungen in vielen Prozessschritten - z.B. vom Produktdesign über Herstellungsprozesse bis hin zur Verpackung durchgeführt. Da aber in der Bestücktechnik beispielsweise zu bestückende Elemente und/oder Substrate häufig zugekauft werden, können Mängel am Produkt bzw. am bestückten Substrat nicht nur durch Fehler im Design oder bei der Produktion verursacht werden, sondern auch durch fehlerhafte Elemente und/oder durch mangelhaftes Substrat.

Da in manchen Einsatzbereichen von bestückten Substraten (z.B. Automotive-Industrie, Flugzeugbau, etc.) sehr hohe Qualitätsstandards gefordert werden, ist - insbesondere in Fall von erkannten Qualitätsmängeln (z.B. fehlerhaftes Substrat, fehlerhafte bestückte Elemente, etc.) - eine Rückverfolgbarkeit bzw. eine so genannte Traceability sehr wichtig. Die Traceability erlaubt einem Hersteller oder einem Inverkehrbringer eines Produkts bei erkannten Qualitätsmängeln einen gezielten Rückruf von Produkten, um beispielsweise Schäden und/oder möglichen Ansprüchen aus der Produkthaftung vorzubeugen. Um bei eine Rückverfolgung bei einem Mangel einer bestückten Leiterplatte bzw. einer ihrer Komponenten (Substrat, bestückte Elemente) zu ermöglichen, muss feststellbar sein, wann, wo, durch wen, etc. das Produkt bzw. die Komponenten hergestellt, verarbeitet, gelagert, etc. worden sind. Um ein Substrat eindeutig identifizieren zu können, weist dieses eine eindeutige Substrat-Identifizierung beispielsweise in Form eines zweidimensionalen Barcodes auf, welche bei den jeweiligen Prozessschritten erfasst wird.

Um die zu bestückenden Elemente verfolgen zu können, besteht derzeit die Möglichkeit, dass beispielsweise eine Charge von zu bestückenden Elementen, welche bestimmte Eigenschaften aufweisen, gekennzeichnet ist. Aus der Schrift EP 1 622 073 A1 ist dazu ein Verfahren bekannt, bei welchem neben dem Substrat auch der Behälter zur Aufbewahrung der Elemente (z.B. Bauelementgurt, Gurtrolle, etc.) mit einer Kennung wie beispielsweise einem Barcode versehen ist. Für die Rückverfolgung gemäß der Schrift EP 1 622 073 A1 werden dann mit Hilfe eines externen Barcode-Readers vor bzw. nach dem Bestücken des Substrats die jeweilige Substrat-Identifikation und die Kennungen der Behälter mit den zu bestückenden Elementen erfasst. Mit dem in der Schrift EP 1 622 073 A1 offenbarten Verfahren können zwar bei einem Qualitätsmangel das verwendete Substrat und die jeweiligen Chargen der bestückten Elemente eruiert werden. Es weist aber den Nachteil auf, dass keine genaue und eindeutige Protokollierung vorliegt, welche Bauelemente und/oder Submodule auf einem bestimmten Substrat bestückt worden sind.

In der Schrift US 2005/0086800 A1 wird ebenfalls ein Verfahren zur Verfolgung von mit Elementen bestückten Substraten offenbart. Dabei sind das jeweilige Substrat sowie die Behälter der zu bestückenden Elemente (z.B. Tray, Bauelementgurt, Gurtrolle, etc.) mit Barcodes oder RFID-Chips versehen, in welchen Informationen über das Substrat bzw. die im Behälter gelagerten Elemente hinterlegt ist. Die Information wird dann beispielsweise beim Laden der Bestückeinrichtung mit dem Substrat bzw. mit den Behältern der zu bestückenden Elemente mittels Scanner oder RFID-Lesegerät ausgelesen und in einer Datenbank abgelegt. Auch dieses Verfahren weist den Nachteil auf, dass eine genaue Nachverfolgung, welche Elemente auf welchem Substrat bestückt sind, nicht möglich ist.

Für eine exakte Nachverfolgung von auf einem Substrat bestückten Elementen kann beispielsweise durch zusätzliche, spätere Prozesse protokolliert werden, welche spezifische Elementen mit definierten Eigenschaften (z.B. spezieller Programmierung, etc.) auf dem jeweiligen Substrat aufgebracht worden sind. Diese Vorgehensweise stellt allerdings einen zusätzlichen, zeit- und kostenintensiven Aufwand dar, da für jedes Substrat nach dem Bestücken zumindest die wesentlichen Elemente - d.h. jene mit spezifischen Eigenschaften - verzeichnet werden müssen, um eine Rückverfolgung zu ermöglichen.

### Darstellung der Erfindung

Der Erfindung liegt daher die Aufgabe zugrunde, ein Verfahren anzugeben, bei welchem auf einfache und kostensparende Weise eindeutige festgestellt werden kann, welche zu bestückenden Elementen auf einem Substrat angebracht sind.

Diese Aufgabe wird durch ein Verfahren der eingangs genannten Art mit den Merkmalen gemäß dem unabhängigen Patentanspruch 1 gelöst. Vorteilhafte Ausführungsformen der vorliegenden Erfindung sind in den abhängigen Ansprüchen beschrieben.

Erfindungsgemäß erfolgt daher die Lösung der Aufgabe mit einem Verfahren der eingangs erwähnten Art, bei dem ein zu bestückendes Element mit einer eindeutigen Kennung versehen wird. Vor einem Bestückvorgang in einer Bestückeinrichtung wird dann die Substrat-Identifikation des jeweils zu bestückenden Substrats erfasst. Beim jeweiligen Bestückvorgang wird die eindeutige Kennung des jeweils zu bestückenden Elements erfasst und dann diese eindeutige Kennung des jeweiligen Elements mit der erfassten eindeutigen Substrat-Identifikation verknüpft.

Der Hauptaspekt der erfindungsgemäß vorgeschlagenen Lösung besteht darin, dass auf einfache und kostensparende Weise bereits während des Bestückens des Substrats mit zu bestückenden Elementen eine eindeutige und nachvollziehbare Verknüpfung zwischen dem jeweiligen Substrat und den darauf bestückten Elementen hergestellt wird. Insbesondere neue Anwendungen aus z.B. der Automotive-Industrie erfordern beispielsweise ein Bestücken von Leiterplatten oder Baugruppen mit so genannten individuellen Elementen (z.B. elektronischen Bauelementen und/oder Submodulen mit speziellen Eigenschaften oder bestimmter Programmierung). Um beispielsweise im Fehlerfall für eine Rückholaktion eine Verbindung zwischen individuellen, bestückten Elementen, dem Substrat und dem Endprodukt (z.B. Auto) zu gewährleisten, wird durch das erfindungsgemäße Verfahren auf einfache Weise eine Verknüpfung der einzelnen zu bestückenden Elemente und dem jeweils zu bestückenden Substrat hergestellt. Dadurch kann dann sehr leicht verfolgt werden, welches Element für ein bestimmtes Endprodukt verwendet worden ist.

Bei einer bevorzugten Fortbildung der Erfindung wird eine Verknüpfung von eindeutiger Substrat-Identifikation und eindeutigen Kennungen der zu bestückenden Elemente elektronisch gespeichert, versendet und Datenverarbeitungseinrichtungen außerhalb der Bestückungseinrichtung zur Verfügung gestellt. Dadurch können auf vorteilhafte Weise die während der Bestückvorgänge erfassten Verknüpfungen z.B. an Traceability-Lösungen weitergeleitet und durch weiterverarbeitet werden.

Es ist vorteilhaft, wenn die eindeutige Kennung der zu bestückenden Elemente mittels eines Scanners oder mittels einer Kamera in der Bestückeinrichtung erfasst wird, da damit auf einfache Weise die eindeutige Kennung des zu bestückenden während des Bestückvorgangs aufgezeichnet werden kann. Der Scanner bzw. die Kamera kann zum Erfassen der Kennung entweder fix oder auch an beweglichen Teilen (z.B. am Bestückkopf, Portalen, etc.) in der Bestückeinrichtung angebracht werden. Es ist z.B. bei einer fixen Anbringung denkbar, dass der Scanner oder die Kamera derart in der Bestückeinrichtung untergebracht ist, dass die eindeutige Kennung des zu bestückenden Elements gescannt bzw. erfasst wird, wenn das zu bestückende Element z.B. mittels Bestückkopf von der Abholposition zur für dieses Element vorgesehenen Stelle auf dem Substrat transportiert wird. Vom Bestückkopf wird das zu bestückende Element beispielsweise über den Scanner bzw. die Kamera bewegt oder unter dem Scanner bzw. der Kamera vorbeigeführt, um die eindeutige Kennung zu erfassen. Andererseits besteht auch die Möglichkeit den Scanner oder die Kamera an einem beweglichen Teil der Bestückeinrichtung wie z.B. dem Bestückkopf oder einem Portal angebracht ist und die eindeutige Kennung beispielsweise beim Aufnehmen eines Elements erfasst wird.

Idealerweise kann als Kamera für ein visuelles Erfassen der eindeutigen Kennung eine Bauelementkamera der Bestückeinrichtung verwendet werden, da auf diese Weise zusätzliche Aufwendungen für einen Einbau einer zusätzlichen Kamera in die Bestückeinrichtung vermieden werden. Die Bauelementkamera wird dabei in einer Doppelfunktion eingesetzt. Es kann mit ihr beispielsweise in einem ersten Schritt eine Bauelementekennung - d.h. ein Erkennen der Geometrie eines zu bestückenden Elements - durchgeführt und dann in einem zweiten Schritt die am zu bestückenden Element angebrachte eindeutige Kennung erfasst werden. Es ist zur Zeitersparnis und zur Beschleunigung des Bestückvorgangs denkbar, die Bauelementekennung und das Erfassen der eindeutigen Kennung mit der Bauelementkamera in einem Schritt durchzuführen.

Es ist auch günstig, wenn die eindeutige Kennung mittels Laser oder per Label außen auf dem zu bestückenden Element angebracht wird. Auf diese Weise kann die Kennung rasch und für eine optische bzw. visuelle Erfassung gut erfassbar aufgebracht werden.

Zweckmäßigerweise ist die eindeutige Kennung des zu bestückenden Elements als Barcode, beispielsweise als zweidimensionaler Barcode, ausgestaltet, da auf diese Weise die Kennung leicht und rasch optisch bzw. visuell erfasst und die in der Kennung enthaltene Information (z.B. Elementtyp, Herstellungsdatum, etc.) auf einfache Weise elektronisch verarbeitet werden kann.

Des Weiteren empfiehlt sich, dass als zu bestückende Elemente mit eindeutiger Kennung elektronische Bauelemente und/oder Submodule vorgesehen werden, wobei diese Elemente individuell spezifische Eigenschaften aufweisen können. Damit kann für jedes bestückte Bauelement bzw. Submodul (z.B. kleiner Baugruppen) festgestellt werden, auf welchem Substrat bzw. auf welcher Leiterplatte es aufgebracht worden ist. Insbesondere bei individuellen Bauelementen bzw. Submodulen, welche beispielsweise aufgrund von spezifischer Programmierung besondere Eigenschaften aufweisen, kann damit auf einfache Weise eine Verbindung zum jeweiligen Endprodukt (z.B. Auto, Flugzeug, etc.) hergestellt werden.

### Kurzbeschreibung der Zeichnung

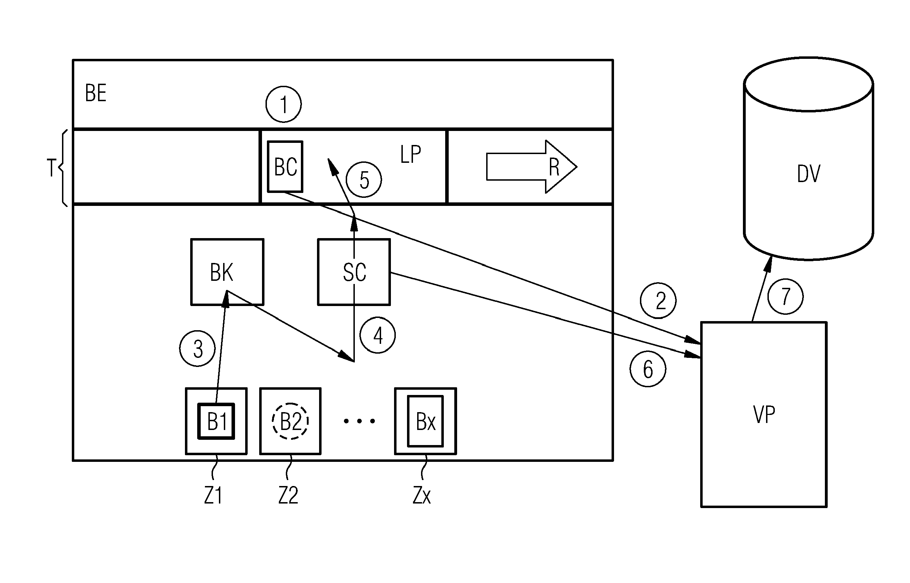

Die Erfindung wird nachfolgend in beispielhafter Weise anhand der beigefügten Figur erläutert. Es zeigt Figur 1 beispielhaft und schematisch einen Ablauf des erfindungsgemäßen Verfahrens zum Erfassen und Verfolgen von zu bestückenden Elementen in einer Bestückeinrichtung.

### Ausführung der Erfindung

Figur 1 zeigt beispielhaft und in schematischer Weise eine Bestückeinrichtung BE wie z.B. einen SMD-Bestückautomat, wobei der Einfachheit halber in Figur 1 nur für das erfindungsgemäße Verfahren wesentliche Komponenten dargestellt sind. So wurde beispielsweise für eine übersichtlichere Darstellung eine Bauelementhalteeinrichtung (z.B. Bestückkopf) weggelassen.

Die in Figur 1 gezeigte Bestückeinrichtung BE umfasst eine Transporteinrichtung T wie beispielsweise ein Fließband, mit welcher ein Substrat bzw. eine Leiterplatte LP in ein Transportrichtung R bewegt wird. Die Leiterplatte LP ist mit einer eindeutigen Substrat-Identifikation BC wie z.B. einem Barcode versehen, welche beispielsweise mittels Laser oder per Label auf dem Substrat bzw. der Leiterplatte LP angebracht worden ist.

Die Bestückeinrichtung BE umfasst weiters eine Kamera BK, mit deren Hilfe eine optische Bauelementekennung durchgeführt wird, und zusätzlich einen Scanner SC für ein Erfassen von eindeutigen Kennungen von zu bestückenden Elemente B1, B2, ..., Bx. Es besteht allerdings auch die Möglichkeit, die Kamera BK für die Bauelementekennung in einer Doppelfunktion eingesetzt wird. Dabei wird zuerst von der Kamera BK die Bauelementekennung - d.h. ein Erkennen der Geometrie eines zu bestückenden Elements - durchgeführt und dann die am jeweils zu bestückenden Elemente B1, B2, ..., Bx angebrachte eindeutige Kennung erfasst. In diesem Fall kann der Scanner SC bei der Bestückeinrichtung BE eingespart werden. Der Scanner SC zum Erfassen der eindeutigen Kennung des zu bestückenden Elements B1, B2, .. Bx kann entweder - wie beispielhaft dargestellt - fix oder an einem beweglichen Teil wie z.B. dem Bestückkopf oder einem Portal in der Bestückeinrichtung BE angebracht sein.

Weiters weist die Bestückeinrichtung BE mehrere beispielhaft dargestellte Zuführeinrichtungen Z1, Z2, ..., Zx auf, von welchen die zu bestückende Elemente B1, B2, ..., Bx (z.B. elektronische Bauelemente, Submodule, etc.), die in Behältern wie z.B. Bauelementgurten, etc. gelagert sind, für Bestückvorgänge an Abholpositionen bereit gestellt werden. Die zu bestückenden Elemente B1, B2, ..., Bx weisen dabei eindeutige Kennungen auf, mit deren Hilfe das jeweils zu bestückende Elemente B1, B2, ..., Bx eindeutig und individuell identifiziert werden kann. Das bedeutet, anhand der eindeutigen Kennung kann z.B. ein zu bestückendes Element (z.B. elektronisches Bauelement, Submodul, etc.) exakt erkannt werden. Damit können beispielsweise Elemente mit speziellen Eigenschaften wie z.B. Bauelemente oder Submodule mit einer individuellen Programmierung leicht erfasst und verfolgt werden. Das ist beispielsweise in Bereichen wie der Automotive-Industrie oder dem Flugzeugbau wichtig, in denen von Lieferanten hohen Qualitätsstandards und eine Rückverfolgbarkeit von Bestandteilen eines Endprodukts gefordert werden.

Die eindeutigen Kennungen auf den Elementen B1, B2, ... Bx sind in Figur 1 der Einfachheit halber allerdings nicht dargestellt. Die eindeutigen Kennungen sind beispielweise auf einer Unterseite der zu bestückenden Elemente B1, B2, ..., Bx angebracht, damit sie von der Kamera BK bzw. dem Scanner SC auf einfache Weise erfasst werden können. Eine Aufbringung der eindeutigen Kennung, welche z.B. als Barcode, insbesondere zweidimensionaler Barcode, ausgeführt sein kann, auf dem jeweiligen Element B1, B2, ..., Bx kann z.B. mittels Laser oder per Label erfolgen.

In einem ersten Verfahrensschritt 1 des erfindungsgemäßen Verfahrens wird vor einem Bestückstückvorgang die Substrat-Identifikation BC der jeweils zu bestückenden Leiterplatte LP erfasst. Das kann beispielsweise beim Einbringen der Leiterplatte LP mit Hilfe der Transporteinrichtung T in die Bestückeinrichtung BE - z.B. mit einem Scanner - erfolgen. In einem zweiten Verfahrensschritt 2 wird dann die erfasste Substrat-Identifikation BC der Leiterplatte LP an eine elektronische Datei VP weitergeleitet. Die elektronische Datei VP kann beispielsweise in einem Speicher der Bestückeinrichtung BE oder in einem zur Bestückeinrichtung gehörenden Station- und/oder Linienrechner eingerichtet und abgelegt sein. Die Leiterplatte LP wird dann von der Transporteinrichtung T an eine Bestückposition bewegt, an welcher mittels Bestückvorgängen die zu bestückenden Elemente B1, B2, ..., Bx aufgebracht werden.

In einem dritten Verfahrensschritt 3 wird für einen Bestückvorgang von einer nicht dargestellten Bauelementhalteeinrichtung wie beispielsweise einem Bestückkopf ein erstes zu bestückendes Element B1 an einer Abholposition aus einer ersten Zuführeinrichtung Z1 entnommen. Das erste zu bestückende Element B1, welches mit einer eindeutigen Kennung versehen ist, wird dann im Verfahrensschritt 3 von der Bauelementhalteeinrichtung für eine Bauelementekennung zur Kamera BK transportiert.

Nach der Bauelementekennung wird das erste zu bestückende Elemente B1 in einem vierten Verfahrensschritt 4 durch die Bauelementhalteeinrichtung bzw. den Bestückkopf über den Scanner SC bewegt. Mit dem Scanner SC wird die z.B. an der Unterseite des ersten zu bestückenden Elements B1 angebrachte eindeutige Kennung erfasst. Wird in einer Bestückeinrichtung BE allerdings die Kamera BK auch zum Erfassen der eindeutigen Kennung eingesetzt, so werden sowohl die Bauelementekennung des dritten Verfahrensschritts 3 also auch der vierte Verfahrensschritt 4 (das Erfassen der Kennung) von der Kamera BK durchgeführt.

In einem fünften Verfahrensschritt 5 wird dann das erste zu bestückende Element B1 von der Bauelementhaltevorrichtung zur Leiterplatte LP verfahren und dort an einer vorgegebenen Position abgesetzt. In einem sechsten Verfahrensschritt 6 wird dann die erfasste eindeutige Kennung des ersten zu bestückenden Elements B1 vom Scanner an die elektronische Datei VP weitergeleitet, in welcher bereits die Substrat-Identifikation BC hinterlegt ist. Mit dem sechsten Verfahrensschritt 6 wird daher die eindeutige Kennung des ersten zu bestückenden Elements B1 mit der Substrat-Identifikation BC verknüpft. Mit dem Absetzen des ersten zu bestückenden Elements B1 und einer Weiterleitung der zugehörigen eindeutigen Kennung wird der Bestückvorgang abgeschlossen.

Für weitere zu bestückende Elemente B1, B2, ..., Bx werden dann ebenfalls die Verfahrensschritte 3 bis 6 durchlaufen. Dadurch werden auch die jeweils zu den weiteren zu bestückenden Elementen B1, B2, ..., Bx gehörenden eindeutigen Kennungen erfasst und mit der Substrat-Identifikation BC z.B. über die elektronische Datei VP verknüpft. Damit kann auf einfache Weise verfolgt werden, welche individuellen Elemente mit z.B. bestimmten Eigenschaften oder einer speziellen Programmierung auf der Leiterplatte LP bestückt worden sind.

Sind alle Bestückvorgänge in der Bestückeinrichtung BE für die Leiterplatte LP abgeschlossen, so kann in einem siebenten Verfahrensschritt 7 die elektronische Datei VP an eine Datenverarbeitungseinrichtung DV (z.B. Datenbank, Traceability-Lösung, etc.) für eine Weiterverarbeitung übertragen werden, welche außerhalb der Bestückeinrichtung BE oder des zugehörigen Stations- und/oder Linienrechners liegen kann. Die elektronische Datei VP kann aber auch im Stations-und/oder Linienrechner für die Weiterverarbeitung gespeichert werden.

Zusätzlich besteht die Möglichkeit jede Verknüpfung zwischen der Substrat-Identifikation BC und einer eindeutigen Kennung eines zu bestückenden Elements B1, B2, ..., Bx an die Datenverarbeitungseinrichtung DV weiterzuleiten. D.h. der siebente Verfahrensschritt 7 wird dann immer unmittelbar nach dem sechsten Verfahrensschritt 6 durchgeführt.

Sind alle Bestückvorgänge für die Leiterplatte LP in der Bestückeinrichtung BE abgeschlossen, so wird die Leiterplatte LP in Transportrichtung R von der Transporteinrichtung T z.B. zur nächsten Bestückeinrichtung BE oder zu einem Reflow-Ofen für einen Lötvorgang in der Bestücklinie weitertransportiert. In die Bestückeinrichtung BE wird dann einen neue Leiterplatte LP eingebracht und wieder alle Verfahrensschritte 1 bis 7 des erfindungsgemäßen Verfahrens für diese neue Leiterplatte LP durchlaufen. Auf diese Weise kann für eine Rückverfolgung exakt festgestellt werden, welche zu bestückenden Elemente B1, B2, ..., Bx auf welcher Leiterplatte LP tatsächlich bestückt worden sind.

## Patentansprüche

1. Verfahren zum Erfassen und Verfolgen von zu bestückenden Elementen (B1, B2, ..., Bx), welche durch einen Bestückvorgang in einer Bestückeinrichtung (BE), insbesondere in SMD-Bestückautomaten, auf ein Substrat (LP) aufgebracht werden, wobei das zu bestückende Substrat (LP) mit einer eindeutige Substrat-Identifikation (BC) versehen ist, **dadurch gekennzeichnet, dass** ein zu bestückendes Element (B1, B2, ..., Bx) mit einer eindeutigen Kennung versehen wird, dass vor einem Bestückvorgang die Substrat-Identifikation (BC) des jeweils zu bestückenden Substrats (LP) erfasst wird (1,2), dass beim Bestückvorgang die eindeutige Kennung des jeweils zu bestückenden Elements (B1, B2, ..., Bx) erfasst wird (3, 4) und dass dann die Kennung des jeweils zu bestückenden Elements (B1, B2, ..., Bx) mit der erfassten eindeutigen Substrat-Identifikation (BC) verknüpft wird (6).

2. Verfahren nach Anspruch 1, **dadurch gekennzeichnet, dass** eine Verknüpfung von eindeutiger Substrat-Identifikation (BC) und eindeutigen Kennungen von zu bestückenden Elementen (B1, B2, ..., Bx) elektronisch gespeichert (6), versendet (7) und Datenverarbeitungseinrichtungen (DV) außerhalb der Bestückeinrichtung (BE) zur Verfügung gestellt wird (7).

3. Verfahren nach einem der Ansprüche 1 bis 2, **dadurch gekennzeichnet, dass** die eindeutige Kennung visuell mittels eines Scanners (SC) oder mittels einer Kamera (BK) in der Bestückeinrichtung (BE) erfasst wird (3,4).

4. Verfahren nach Anspruch 3, **dadurch gekennzeichnet, dass** als Kamera (BK) für ein visuelles Erfassen der eindeutigen Kennung eine Bauelementkamera der Bestückeinrichtung (BE) verwendet wird (3, 4).

5. Verfahren nach einem der Ansprüche 1 bis 4, **dadurch gekennzeichnet, dass** die eindeutige Kennung mittels Laser oder per Label außen auf dem zu bestückende Element (B1, B2, ..., Bx) angebracht wird.

6. Verfahren nach einem der Ansprüche 1 bis 5, **dadurch gekennzeichnet, dass** die eindeutige Kennung als Barcode ausgestaltet wird.

7. Verfahren nach einem der Ansprüche 1 bis 6, **dadurch gekennzeichnet, dass** als zu bestückende Elemente (B1, B2, ..., Bx) mit eindeutiger Kennung elektronische Bauteile und/oder Submodule vorgesehen werden.
